(19) Europäisches Patentamt
European Patent Office
Office européen des brevets

(11) EP 3 032 599 A1

(12) # EUROPEAN PATENT APPLICATION

(43) Date of publication:
**15.06.2016 Bulletin 2016/24**

(51) Int Cl.:
***H01L 51/05*** *(2006.01)*

(21) Application number: **14197724.9**

(22) Date of filing: **12.12.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Solvay SA**
**1120 Bruxelles (BE)**

(72) Inventors:
- **Maunoury, Jonathan**
  **1030 Brussels (BE)**
- **Fenoll, Mathieu**
  **1030 Schaerbeek (BE)**
- **Caille, Jean-Raphael**
  **5000 Namur (BE)**
- **Catinat, Jean-Pierre**
  **7131 Waudrez (BE)**

(74) Representative: **Dr. Langfinger & Partner**
**In der Halde 24**
**67480 Edenkoben (DE)**

(54) **Organic semiconductor composition**

(57) Organic semiconductor composition, comprising an organic semiconductor (OSC) material and a binder which is a spirobifluorene compound comprising 1 to 4 substituted or unsubstituted spirobifluorene moieties of formula

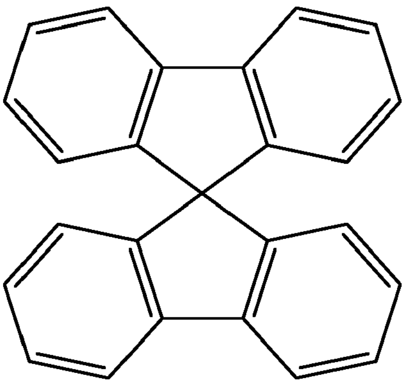

EP 3 032 599 A1

## Description

The present invention relates to an organic semiconductor composition and the use thereof for the manufacture of organic electronic devices.

Organic semiconducting materials have been the subject of intense research and development efforts in the recent years in order to produce electronic devices at lower cost.

Organic semiconducting materials are used for the manufacture of organic field effect transistors, organic light emitting diodes, photodetectors, organic photovoltaic devices, sensors, memory elements to name just a few examples. The organic semiconducting materials are typically present in the said electronic devices in the form of a thin layer.

Improved charge mobility as well as improved stability and integrity of the organic semiconductor layer are important factors to be achieved for a successful use of organic semiconductor materials in the manufacture of said devices.

For organic field effect transistor devices solution processible organic semiconducting layers are of particular interest. The organic semiconducting materials should be solution-based and solution based deposition methods like spin-coating, slot-die coating and doctor blade coating or printing methods such as flexible and screen printing would be desirable. A key requirement for these applications is a good adhesion of the organic semiconducting layer to the underlying layer as well as to the layer deposited on top of the organic semiconducting layer.

One way to improve stability of the layer and the integrity thereof in devices is to include the organic semiconducting material in an organic binder.

Polymeric binders are commonly used with solution processed organic semiconducting materials to increase the performance of organic field effect transistors or to improve the processability of the organic semiconductor formulation. Respective compositions are described e.g. in US 2004/38,459 and in WO 2005/55,248.

WO 2007/82,584 discloses electronic components or devices comprising a gate electrode, a source electrode and a drain electrode and further an organic semiconducting material provided between the source and the drain electrode which comprises one or more organic semiconducting compounds and an organic binder which preferably is selected from polyarylamines, polyfluorenes, polyindenofluorenes, polyspirobifluorenes, polysilanes, polythiophenes, copolymers of one of the aforementioned polymers and polyarylamine-butadiene copolymers.

WO 2014/008971 discloses organic electronic devices comprising an organic semiconducting layer comprising an organic semiconductor and an organic binder wherein the organic binder comprises a compound comprising one or more divalent units selected from the following formula

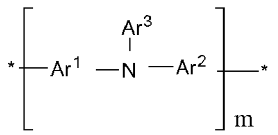

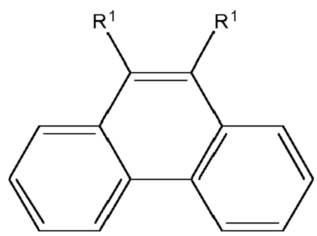

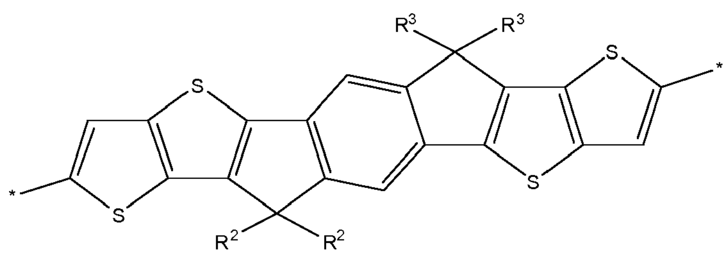

According to claim 2 of this document the organic binder may be a small molecule derived from the first formula shown above wherein m is 1, 2 or 3.

WO 2012/164,282 discloses an organic semiconductor composition comprising a polyacene compound and

an organic binder, wherein the organic binder is a semiconducting binder having a permittivity at 1000 Hz of between 3.4 and 8.0. The binders described in this document are all polymers.

Semiconductor compositions containing the commonly used polymer binders, however, have some drawbacks in certain applications, like for example weak adhesion to available top coatings such as gate dielectrics or passivation layers.

There exists an ongoing need to develop and provide organic semiconductor compositions having improved properties and overcoming the drawbacks mentioned above, for use in the manufacture of organic electronic devices.

It was thus an object of the present invention to provide novel and improved organic semiconductor compositions useful for the manufacture of organic electronic devices, e.g. organic field effect transistors.

This object is achieved by the organic semiconductor compositions in accordance with claim 1.

Preferred embodiments of the present invention are set forth in the dependent claims and the detailed specification hereinafter.

The organic semiconductor compositions in accordance with the present invention comprise as component a) an organic semiconductor material.

Preferred organic semiconducting materials which can be used in the present invention have a field effect mobility of at least 0.001 $cm^2/Vs$, preferably of at least 0.1 $cm^2/Vs$, even more preferably more than 1 $cm^2/Vs$ cm. The mobility referred to here is preferably determined in the saturation mode using a field effect transistor. In this technique, for each fixed gate voltage $V_{GS}$ the drain-source voltage $V_{DS}$ is increased until the current $I_O$ saturates. Next, the square root of this saturated current is plotted against the gate voltage and the slope $m_{sat}$ is measured. Then the mobility is

$$\mu = m_{sat}^2 \, 2L/WC_i$$

where L and W are the length and width of the channel and $C_i$ is the gate insulator capacitance per unit area.

Whereas in principle any kind of semiconducting organic material can be used, small molecule organic semiconductors have a molecular weight of 1500 Dalton or less, preferably 1000 Dalton or less and most preferably 800 Dalton or less are generally advantageous.

In accordance with a preferred embodiment the organic semiconductor is chosen such that it exhibits a high tendency to crystallize when solution coating methods are used.

There are no specific limitations as to the structure of the organic semiconducting material in the compositions of the present invention and thus the skilled person can select the organic semiconductor based on his professional knowledge and adopted to the specific application circumstances.

Exemplary small molecule organic semiconductors are selected from compounds of formulae

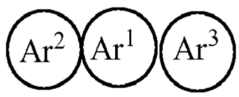

(1)

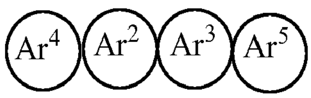

(2)

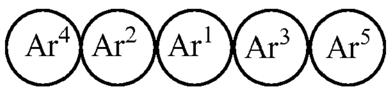

(3)

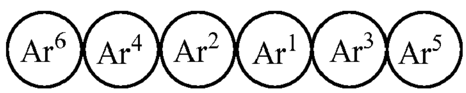

(4)

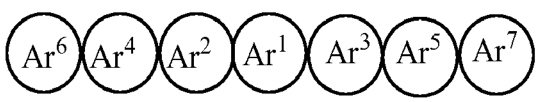

(5)

wherein $Ar_1$ to $Ar_7$ are the same or different at each occurrence and are each independently selected from the group consisting of monocyclic aromatic rings and monocyclic heteroaryl aromatic rings, with at least one of $Ar^1$ to $Ar^7$ being substituted with at least one substituent X which may be the same or different at each occurrence and is selected from the group consisting of unsubstituted or substituted straight, branched or cyclic alkyl groups having from 1 to 50 carbon atoms, alkoxy groups having from 1 to 50 carbon atoms, aryloxy groups having from 6 to 40 carbon atoms, alkylaryloxy groups having from 7 to 40 carbon atoms, alkoxycarbonyl groups having from 2 to 40 carbon atoms, aryloxycarbonyl groups having from 7 to 40 carbon atoms, amino groups that may be unsubstituted or substituted with one or two alkyl groups having from 1 to 20 carbon atoms, each of which may be the same or different, amido groups, silyl groups that may be unsubstituted or substituted with one, two or three alkyl groups having from 1 to 20 carbon atoms, silylethinyl groups that may be unsubstituted or substituted with one, two or three alkyl groups having from 1 to 20 carbon atoms, alkenyl groups having from 2 to 20 carbon atoms, the carbamoyl group, the haloformyl group, the formyl group, the cyano group, the isocyano group, the isocyanate group, the thiocyanate group, the thioisocyanate group, OH, nitro, cyano, haloalkyl groups having 1 to 20 carbon atoms and wherein $Ar^1$, $Ar^2$ and $Ar^3$ may each optionally be fused to one or more further monocyclic aromatic or heteroaromatic rings.

In accordance with a preferred embodiment at least one of $Ar^1$ to $Ar^7$ comprises a 5 to 7 membered heteroaryl group containing from 1 to 3 sulfur atoms, oxygen atoms, selenium atoms and/or nitrogen atoms.

In a still further embodiment $Ar^1$ to $Ar^7$ are independently selected from phenyl and thiophene and at least one of $Ar^1$ to $Ar^7$ is thiophene.

A first group of small molecule organic semiconductors in accordance with the above general formulae which can be used in the compositions of the present invention are oligo-and polyacenes.

Acenes or polyacenes are a class of organic compounds and parties cyclic aromatic hydrocarbons made up of linearly fused benzene rings, i.e. having a skeleton of general formula (6)

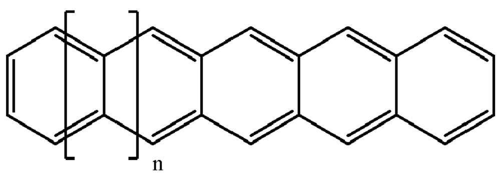

(6)

which may be substituted with substituents X as defined above in any position. In preferred compounds of this group n is an integer in the range of from 1 to 4.

Pentacene compounds for which n is 1 have been used in a number of applications for the manufacture of organic electronic devices.

Exemplary representatives of suitable pentacene compounds are represented by formulae (7) to (14)

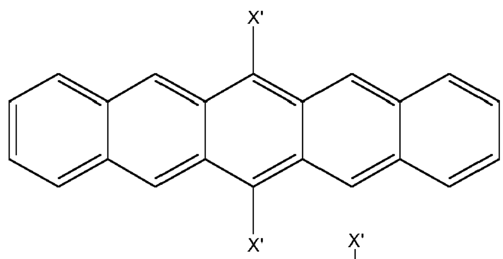

(7)

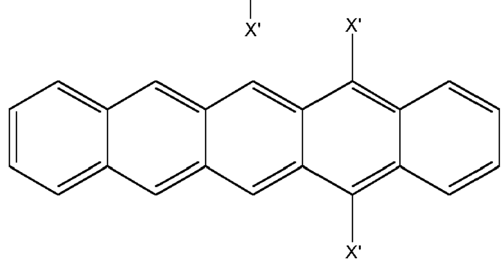

(8)

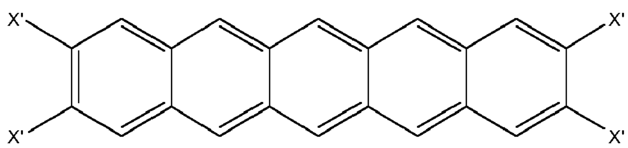

(9)

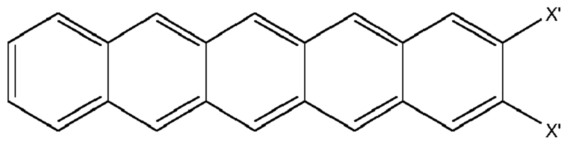
(10)

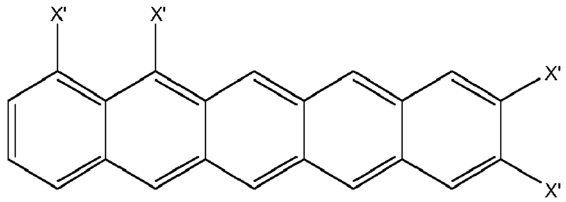
(11)

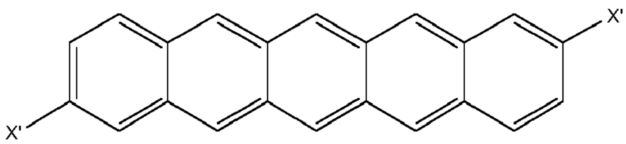
(12)

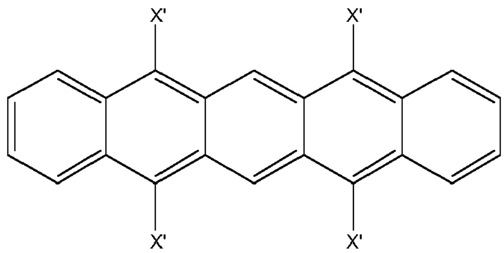
(13)

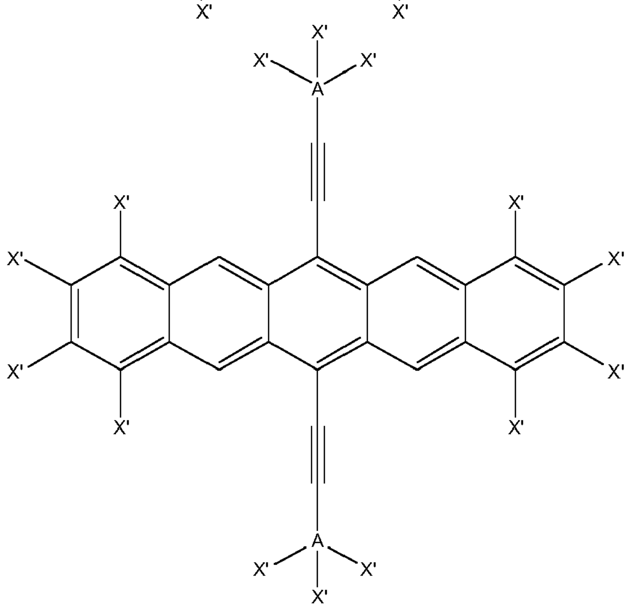
(14)

in which X', which may be the same or different at each occurrence, is hydrogen or has a meaning as defined above for X, with the proviso that at least one substituent X' is different from hydrogen, and wherein A is carbon, silicon or germanium, preferably silicon or germanium. The substituents X' at the atom A in this case are preferably alkyl groups or alkoxy groups having from 1 to 20, preferably from 1 to 12 and even more preferably 1 to 8 carbon atoms.

Another group of suitable acenes are analogues of compounds to formula (14) with three instead of five fused benzene rings, i.e. derivatives of anthracene.

Still another group of compounds corresponding to formula 3 is represented by formula (15)

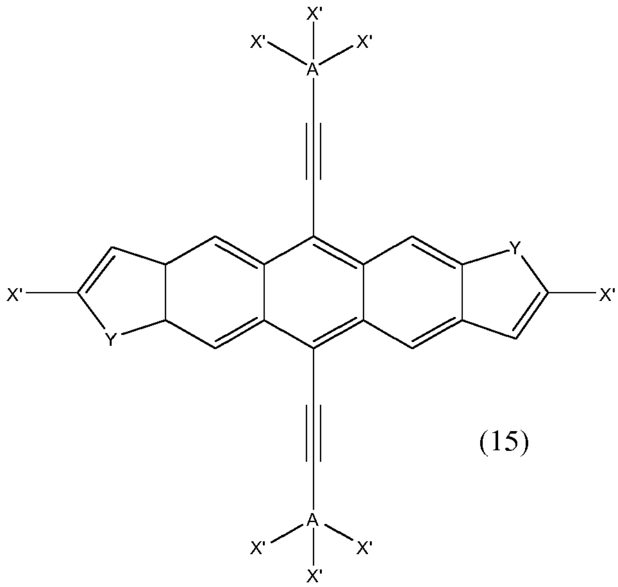

(15)

wherein again X' and A are as defined above and may be the same or different at each occurrence and wherein Y is selected from the group consisting of S, NH, NX' or Se, preferably from S or Se. The substituents X' at the atom A in this case are preferably alkyl groups or alkoxy groups having from 1 to 20, more preferably from 1 to 12 and even more preferably from 1 to 8 carbon atoms and the substituent X' in NX' is an alkyl group having from 1 to 12, more preferably from 1 to 8 carbon atoms.

Another group of compounds of general formula (2) preferred as organic semiconductors in the present invention are compounds of general formula (16)

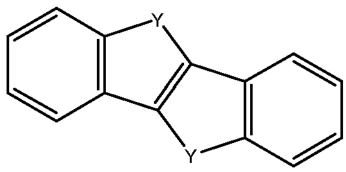

(16)

wherein Y is as defined above for formula (15) and which may bear substituents X' as defined above at any of the carbon atoms of the ring system.

Still another group of preferred organic semiconductors in the compositions of the present invention are furan or thiophene V-shaped organic semiconducting materials of general formula

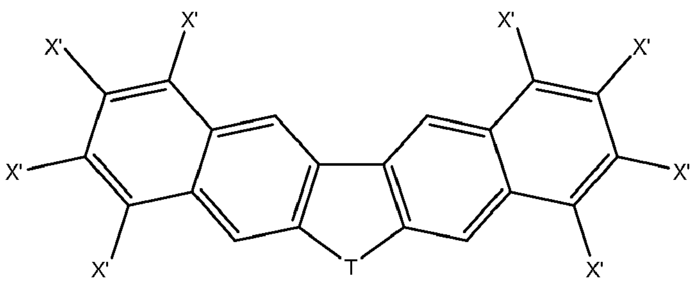

wherein T is an oxygen or a sulfur atom and X', which may be the same or different at each occurence, may have the meaning as defined above.

Representative examples are

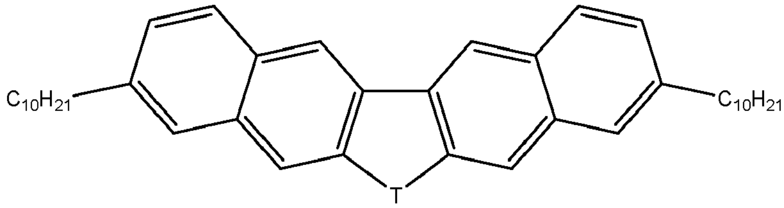

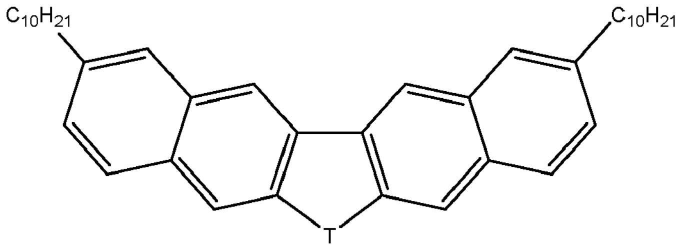

wherein T is preferably oxygen.

Preferred compounds of this structure as well as their synthesis have been described in Chem. Comm. 2014, 50, 5342-5344 to which reference is made for further details.

Particularly preferred examples for compounds of formula (14) are the compounds of formulae (17) to (19) which are generally known under the names given next to the formula

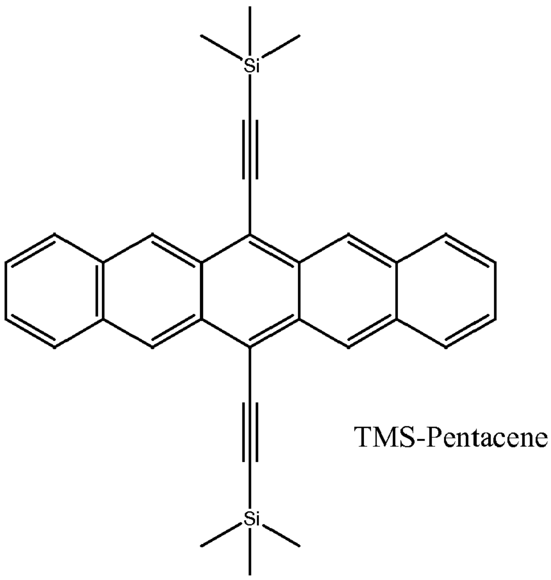

(17)

TMS-Pentacene

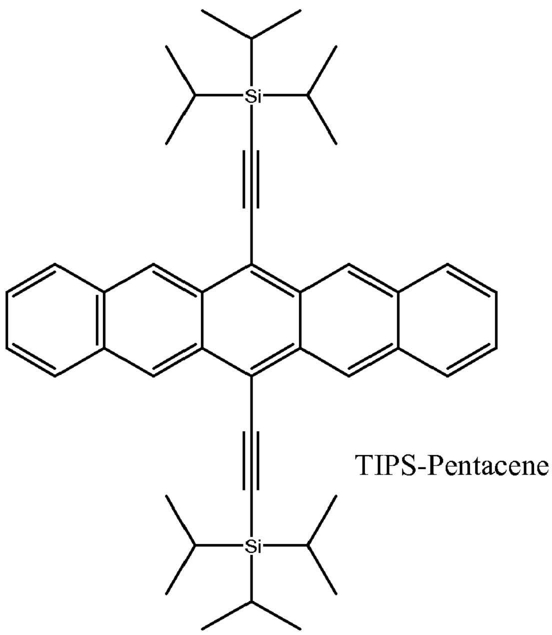

(18)

TIPS-Pentacene

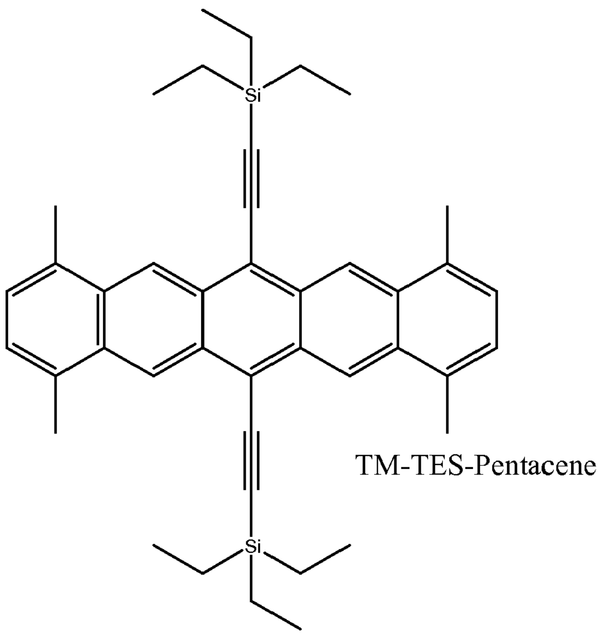

(19)

TM-TES-Pentacene

A preferred organic semiconductor corresponding to a general formula (15) is represented by formula (20)

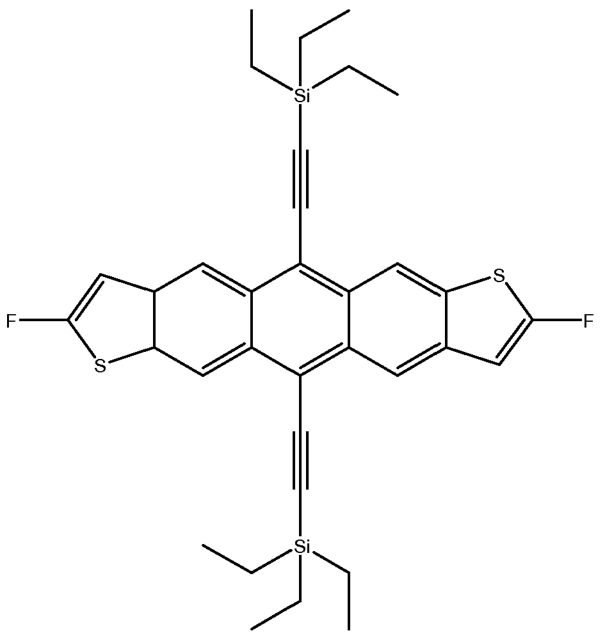

(20)

diF-TES-ADT

Particularly preferred representatives of general formula (16) are benzothieno benzothiophene derivatives represented by general formula (21) below

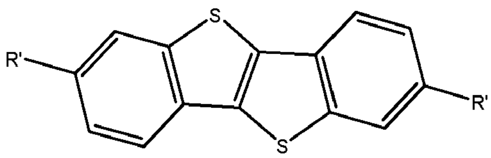

(21)

wherein R', which may be the same or different, represents an alkyl group having 1 to 30, preferably from 1 to 20 and most preferably from 1 to 12 carbon atoms. A particularly preferred compound of this group is known as C8-BTBT in which both substituents R' are n-$C_8H_{17}$ (n-octyl) groups.

Another group of preferred organic semiconductors corresponding to a general formula (1) is represented by formula (22)

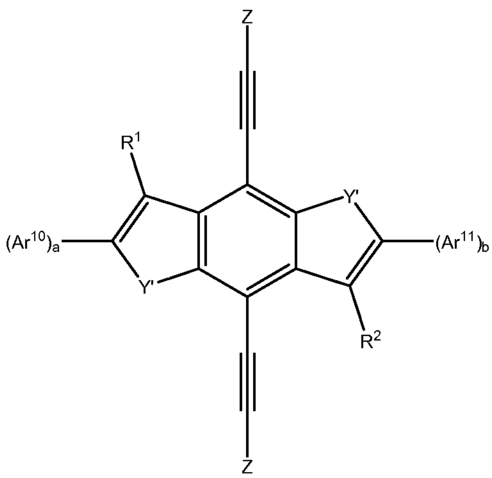

(22)

wherein

Y', which may be the same or different at each occurrence, is selected from S or Se,

$Ar^{10}$ and $Ar^{11}$, which may be the same or different at each occurrence, are an aryl group or heteroaryl group that is optionally substituted with one or more groups $R^3$ or denote $CX^1$=$CX^2$ or C≡C,

$R^1$, $R^2$ and $R^3$, which may be the same or different at each occurrence, are hydrogen, or straight chain, branched or cyclic alkyl with 1 to 50 carbon atoms, which may be unsubstituted or substituted by one or more of F, Cl, Br, I or CN, it being also possible for one or more non-adjacent $CH_2$-groups to be replaced, in each case independently from one another, by-O-, -S-, NH, $NR^4$, $SiR^5R^6$, -C(=O)-, -C(=O)O-, -OC(=O)-O-, -S-C(=O)-,-C(=O)-S-, CH=CH or -C≡C- in such a manner that oxygen and sulfur atoms are not linked directly to one another,

$X^1$ and $X^2$, independently of each other are H, F, Cl or CN,

$R^4$, $R^5$ and $R^6$, independent of each other, are hydrogen or alkyl with 1 to 20 carbon atoms, and

Z is $R^3$ or $SiR^7R^8R^9$ with

$R^7$, $R^8$ and $R^9$, independently of each other, representing hydrogen, straight chain, branched or cyclic alkyl or alkoxy groups with 1 to 50 carbon atoms or aryl, arylalkyl or arylalkyloxy groups with 6 respectively 7 to 40 carbon atoms, wherein all these groups may be substituted with one or more halogen atoms.

Semiconducting materials of general formula (22) are described extensively in WO 2008/011,957 to which reference is made here for more details.

WO 2012/076092 discloses compounds of general formula (23)

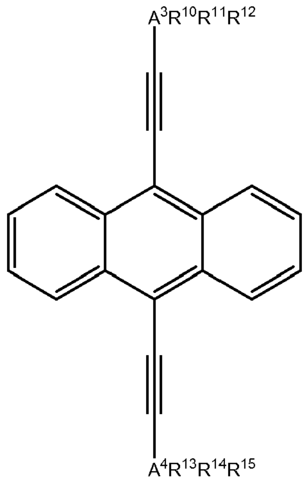

(23)

wherein the hydrogen atoms at each of the carbon atoms of the fused ring system may be substituted with a substituent X' as defined above,

$A^3$ and $A^4$ are Si, C or Ge, and

$R^{10}$ to $R^{15}$, independently of each other, are selected from the group consisting of hydrogen, straight-chain, branched or cyclic alkyl or alkoxy having 1 to 50 carbon atoms, straight-chain, branched or cyclic alkenyl having 2 to 40 carbon atoms, straight-chain, branched or cyclic alkynyl with 2 to 50 carbon atoms, straight chain, branched or cyclic alkylcarbonyl with 2 to 50 carbon atoms, arylalkyl or heteroarylalkyl with 4 to 30 ring atoms, aryloxy or heteroaryloxy with 4 to 30 ring atoms or arylalkyloxy or heteroarylalkyloxy with 4 to 30 ring atoms, which groups may bear further substituents L, wherein

L is selected from F, Cl, Br, I, -CN, NO2, -NCO, -NCS, -OCN, -SCN, - C(=O)$NR^5R^6$, -C(=O)Hal, -C(=O)-$R^4$, -$NR^4R^5$, -C(=O)-OH, optionally substituted aryl or heteroaryl having 4 to 30 ring atoms, or straight-chain, branched or cyclic alkyl with 1 to 50, preferably 1 to 20 and more preferably 1 to 12 carbon atoms, wherein one or more non-adjacent methylene groups are optionally replaced by, in each case independently from one another, by -O-, -S-, -$NR^4$-, -C-$Y^0$=$CY^{00}$- or $SiR^5R^6$ in such a manner that oxygen and/or sulfur atoms are not linked directly to one another, with $R^4$, $R^5$ and $R^6$ being as defined above, and

$Y^0$ and $Y^{00}$, independently of each other, denote H, F, Cl, Br and CN.

In the compounds of general formula (23) adjacent substituents X' can be cross-bridged with each other to form a saturated or unsaturated ring.

Further details concerning compounds of formula (23) are given in WO 2012/076029 to which reference is made here with in this regard.

Further examples for acene semiconductors are disclosed in WO2006/125,504, WO2005/055,248,

WO2007/082584, WO2011/031,659, WO2012/160383, WO2012/164,282 and WO 2013/041,822, to which reference is made at this point for further details.

An example for another group of suitable organic semiconductors is represented by general formula (24)

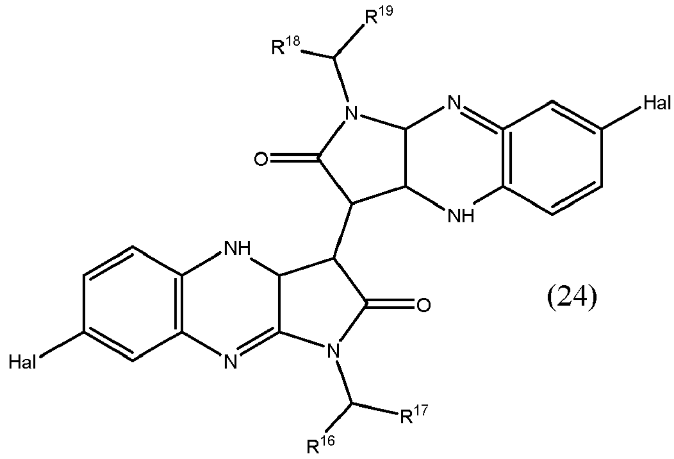

(24)

in which Hal stands for a halogen atom, preferably F, and $R^{16}$ to $R^{19}$, which may be the same or different at each occurrence, are independently selected from straight-chain, branched or cyclic alkyl groups with 1 to 40 carbon atoms, preferably from alkyl groups having 1 to 12, even more preferably 1 to 8 carbon atoms.

A particularly preferred representative of the compounds of formula (24) is the compound of formula (25) (1,1'-di(decan-5-yl)-7,7'-difluoro-1H,1'H-3,3'-bipyrrolo[2,3-b]quinoxaline-2,2'(4H,4'H)-dione )

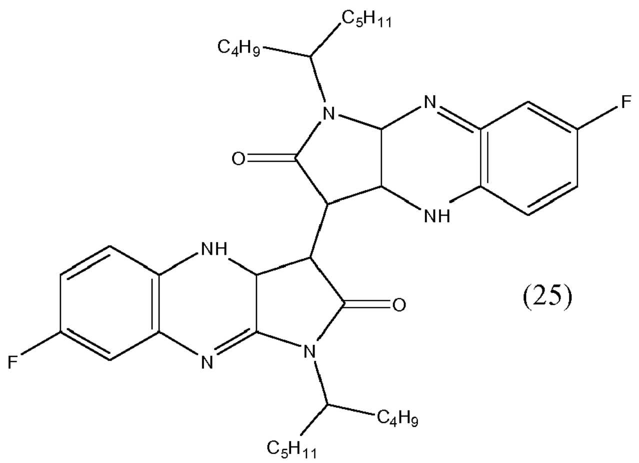

(25)

The synthesis of compounds of formula (24) or (25) is exemplified in a reaction scheme below:

Step 1:

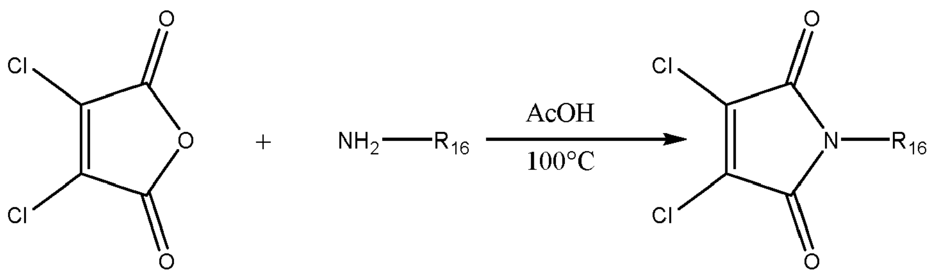

wherein $R_{16}$ is preferably an optionally substituted alkyl chain

Step 2:

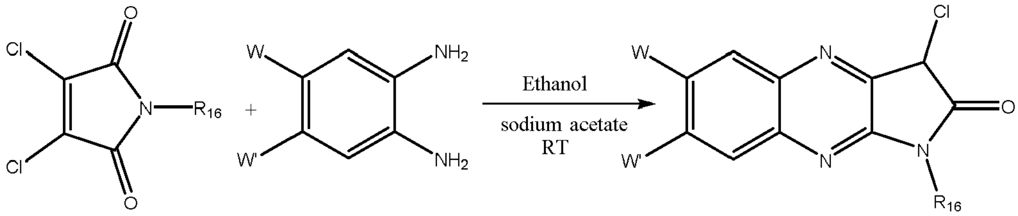


wherein W and W' are as defined below

Step 3:

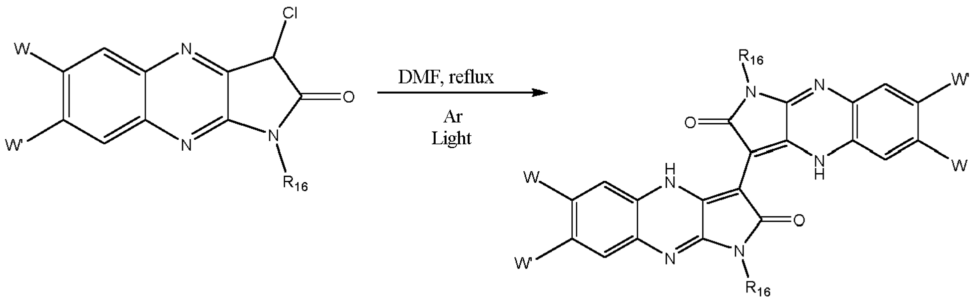


wherein

W and W', independent of one another, may be hydrogen, halogen, CN, COOH,-$COOR_a$, C(=O)-$R_a$, OH, $OR_a$, $C_1$-$C_8$ alkyl, $C_1$-$C_8$ haloalkyl, SCN, $NH_2$, $N(R_aR_b)$, $(O-CH_2-CH_2)_n$-OH, substituted or unsubstituted $C_5$-$C_{30}$ aryl, substituted $C_2$-$C_{20}$ heteroaryl, $C_2$-$C_{20}$ alkenyl, $C_2$-$C_{20}$ alkinyl, $Sn(R_a)_3$, $B(OR_a)_2$ and $Si(R_a)_3$, B and B', which may be the same or different, may be C, N or P, preferably C or N, $R_a$ and $R_b$, which may be the same or different, are selected from $C_1$-$C_{20}$ hydrocarbyl groups or $C_1$-$C_{20}$ heterohydrocarbyl groups, preferably from $C_1$-$C_{12}$ alkyl groups. Detailed information on compounds of formula (24) and (25) is given in PCT/EP 2014/060845, assigned to the applicant hereof and to which reference is made for further details.

The organic semiconductors described above are either commercially available from various sources or processes for their manufacture are disclosed in the references cited in this regard. The skilled person will select the best suited semiconductor based on his professional experience and adopted to the special application situation.

The binder b) in the semiconductor compositions in accordance with the present invention is a spirobifluorene compound comprising 1 to 4, preferably 1 to 3 and even more preferably 1 to 2, substituted or unsubstituted spirobifluorene moieties of formula

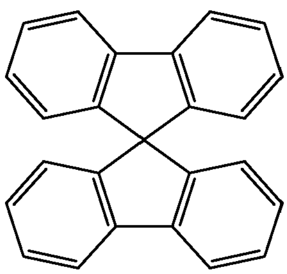

(26)

In principle, there is no specific structural limitation in the spirobifluorene compounds used as binder in the compositions of the present invention. The skilled person can thus select the most suitable spirobifluorene compound based on his professional experience and on the specific application situation he is faced with. The spirobifluorene compounds described hereinafter have shown to be advantageous in a number of applications.

Preferred spirobifluorene compounds have a molecular weight of 1500 Dalton or less, preferably of less than 1200 Dalton or less and most preferred of 1000 Dalton or less.

Spirobifluorene compounds having a glass transition temperature of at least 120°C, preferably of at least 130 °C and even more preferably of at least 140 °C are preferred.

This spirobifluorene moiety may be substituted or unsubstituted with a variety of substituents in different positions.

Thus, a first preferred group of suitable spirobifluorene compounds may generally be described by the following formula (27)

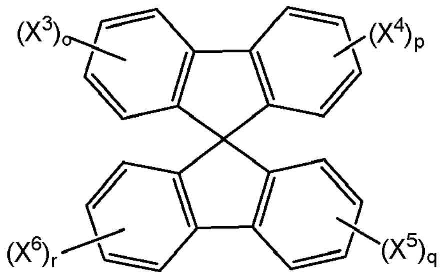

(27)

wherein $X^3$ to $X^6$ are independently selected from substituents other than hydrogen and o, p, q and r, independently of one another represent an integer of from 0 to 4.

Preferred substituents $X^3$ to $X^6$ are $C_1$-$C_{50}$ hydrocarbyl- or $C_1$-$C_{50}$ heterohydrocarbyl groups.

Examples for $C_1$-$C_{50}$ hydrocarbyl or $C_1$-$C_{50}$ heterohydrocarbyl groups are alkyl, alkoxy, substituted amino, cyano, alkenyl, alkynyl, arylalkyl, aryl and heteroaryl groups. Preferred are respective groups with 1 to 30 and in particular with 1 to 20 and most preferably with 1 to 12 carbon atoms. Two substituents may also form an annealed ring system with other rings selected from cycloalkyl, aryl and heteroaryl rings.

Preferred substituents are also halogen or amino.

Preferred aryl groups comprise 5 to 30 carbon atoms, more preferably from 6 to 14 carbon atoms.

Exemplary heteroaryl rings are preferably derived from the heteroarenes group consisting of 2H-pyrrole, 3H-pyrrole, 1H-imidazole, 2H-imidazole, 4H-imidazole,1H-1,2,3-triazole, 2H-1,2,3-triazole, 1H-1,2,4-triazole, 1H-pyrazole, 1H-1,2,3,4-tetrazole, imidazol-2-ylidene, oxazole, isoxazole, thiazole, isothiazole, 1,2,3-oxadiazole, 1,2,5-oxadiazole, 1,2,3-thiadiazole and 1,2,5-thiadazole rings.

Spirobifluorene compounds of this type have been described in the prior art and representatives of these compounds are commercially available from various sources.

Among the spirobifluorene compounds those having a substituent of the type defined before in 3-position of the spirobifluorene moiety are preferred. A first group of preferred 3-substituted spirobifluorene compounds which are represented by general formula (28) has been described in detail in WO 2012/048819 to which reference is made in this regard as far as methods for the manufacture and further properties of these 3-substituted spirobifluorene compounds are concerned

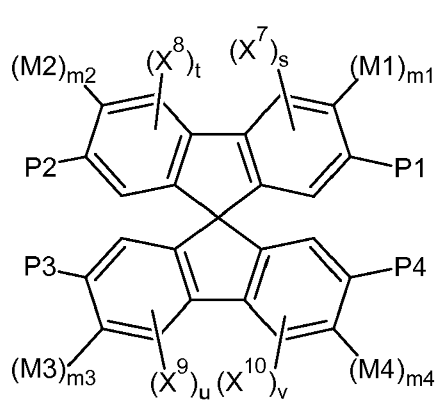

(28)

wherein

M1 to M4, which may be the same or different, represent halogen, -CN, - SCN, -OCN, $OR^{20}$, $SR^{21}$, -B($OR^{22}R^{23}$) or -O-($SO_2$)-$R^{24}$, m1, m2, m3 and m4, which may be the same or different, are individually 0 or 1. Preferably, the sum of m1+m2+m3+m4 is an integer of from 1 to 3.
$R^{20}$ represents $C_1$ to $C_{20}$ alkyl, $C_2$-$C_{20}$-alkenyl, $C_2$-$C_{20}$ alkinyl, arylalkyl, aryl or heteroaryl or may form an annealed ring system with other rings selected from cycloalkyl, aryl and heteroaryl rings,
$R^{21}$ to $R^{24}$, which may be the same or different, represent hydrogen, $C_1$ to $C_{20}$ alkyl, $C_2$-$C_{20}$-alkenyl, $C_2$-$C_{20}$ alkinyl, arylalkyl, aryl or heteroaryl or may form an annealed ring system with other rings selected from cycloalkyl, aryl and heteroaryl rings,
P1 to P4, which may be the same or different, represent hydrogen, $C_1$ to $C_{20}$ alkyl, $C_2$-$C_{20}$-alkenyl, $C_2$-$C_{20}$ alkinyl, arylalkyl, aryl or heteroaryl or may form an annealed ring system with other rings selected from cycloalkyl, aryl and heteroaryl rings,
$X^7$ to $X^{10}$, which may be the same or different, represent, $C_1$ to $C_{20}$ alkyl, $C_2$-$C_{20}$-alkenyl, $C_2$-$C_{20}$ alkinyl, arylalkyl, aryl or heteroaryl or may form an annealed ring system with other rings selected from cycloalkyl, aryl and heteroaryl rings and
m, n. p and q, which may be the same or different, are an integer of from 0 to 2.

Another preferred subgroup of SBF compounds of formula (27) bears at least one substituent in 3, 3', 6 and/or 6' position and is represented by the general formula (29)

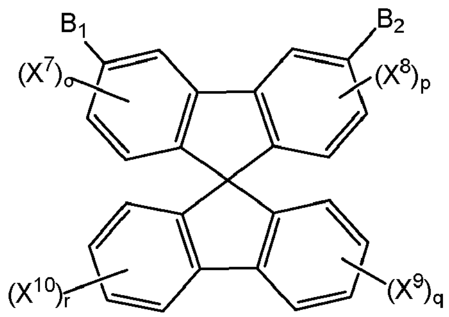

(29)

wherein $B_1$ and $B_2$ are independently selected from hydrogen and a heterocyclic group provided that $B_1$ and $B_2$ are not hydrogen simultaneously, and $X^7$ to $X^{10}$ and o, p, q and r are as defined above.
The heterocyclic group $B_1$ and/or $B_2$ can be preferably selected from, but is not limited to, carbazole, dibenzothiophene, dibenzofurane, acridine, dibenzosilole, and bipyridine each of which is optionally substituted by one or more substituents other than hydrogen.
In one specific embodiment, the heterocyclic group is represented by the following formula

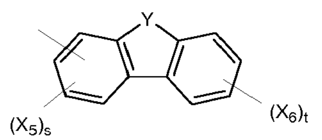

wherein Y is N-R, O, S, Si(R)$_2$, where R is $C_{1-50}$ alkyl or $C_{6-40}$ aryl; $X_5$ and $X_6$ are independently selected from substituents other than hydrogen; s is an integer of from 0 to 3 and t is an integer of from 0 to 4.
In another embodiment, the heterocyclic group is represented by the formula

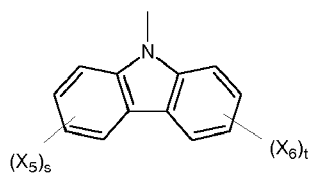

wherein $X_5$ and $X_6$ are independently selected from substituents other than hydrogen; and s and t are independently

selected from integers of from 0 to 4.

Compounds of formula (29) and processes for their manufacture have been described in WO 2012/48820 to which reference is made here for further details.

Still another preferred group of 3-substituted spirobifluorene compounds which may be used as binder in the compositions in accordance with the present invention are spirobifluorene compounds disclosed in WO 2013/045408 and represented by general formulae (29) to (32)

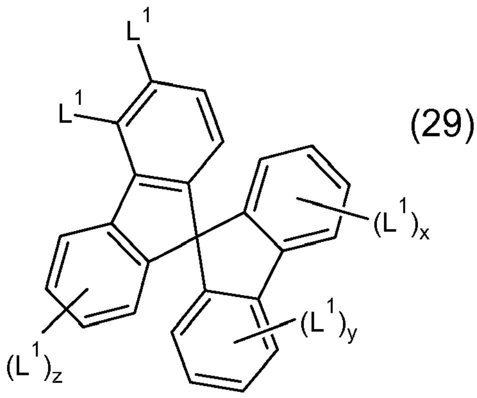
(29)

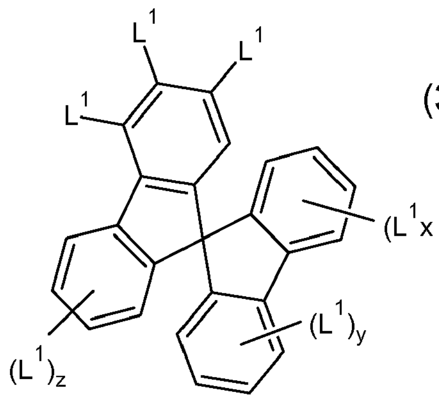
(30)

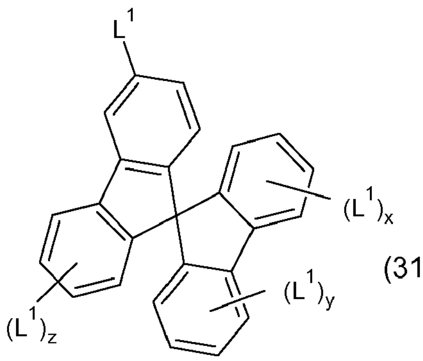
(31)

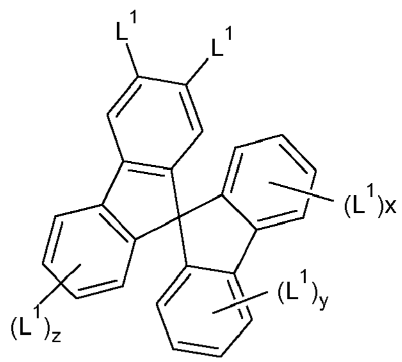
(32)

wherein x, y and z may be the same or different and represent an integer of from 0 to 3,
each of the phenyl rings may carry no ligands other than $L^1$ or may be substituted by ligands other than $L^1$,
$L^1$, which may be the same or different in each position shown, is a heteroatom not being part of a ring system and bound to the fluorene system, i.e. the SBF or open SBF system, selected from the group consisting of N, O, S and P, which heteroatom is substituted by at least one $C_5$-$C_{20}$-aryl or $C_1$ to $C_{20}$-heteroaryl group.
$L^1$ is preferably represented by one of the following formulae

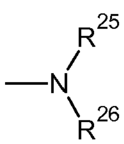

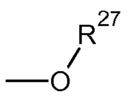

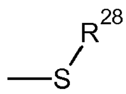

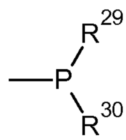

$—P(=O)R^{31}R^{32}$

$—S(=O)R^{33}$

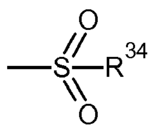

wherein $R^{25}$ to $R^{34}$, which may be the same or different, represent a $C_5$ to $C_{20}$ aryl or a $C_1$ to $C_{20}$ heteroaryl group.

Particularly preferred are compounds where $L^1$ is selected from $-NR^{25}R^{26}$, $OR^{27}$ and $SR^{28}$, especially preferably $L^1$ is $-NR^{25}R^{26}$.

The aryl or heteroaryl group carried by the heteroatom is preferably selected from $C_6$ to $C_{18}$ aryl or $C_1$ to $C_{18}$

heteroaryl groups.

Preferred aryl groups are phenyl, napththyl, anthracenyl, biphenyl or terphenyl, which may be unsubstituted or substituted by substituents selected from the group consisting of halogen, alkyl, alkoxy, amino, cyano, alkenyl, alkynyl, arylalkyl, aryl and heteroaryl groups or the aryl group may be part of an annealed ring system.

Especially preferred aryl substituents are derived from the following substituted or unsubstituted aryl systems

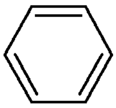

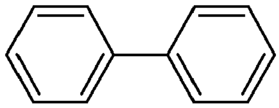

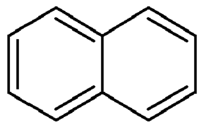

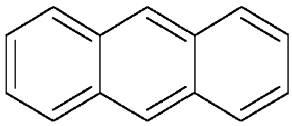

of which phenyl and biphenyl are especially preferred.

Further information for compounds of this type can be found in WO 2013/045408, to which reference is made here with for more details.

Spirobifluorene compounds with substituents of the acridine type are disclosed in WO2013/045410, to which reference is made herewith for further details. In these compounds $L^1$is represented by general formula (33)

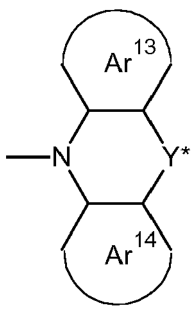

(33)

wherein

Y* is selected from the group consisting of O, S, C=O, $-CR^{34}R^{35}$, N-R36, S=O, $S(=O)_2$, $PR^{37}$ and $P(=O)R^{38}$,
$R^{34}$ to $R^{38}$ may be the same or different in each position and represent hydrogen or an aliphatic, carbocyclic, aromatic or heterocyclic group with 1 to 20 carbon atoms, and
$Ar^{13}$ and $Ar^{14}$ represent optionally substituted aromatic or heteroaromatic ring systems comprising 4 to 20 ring atoms (the two ring atoms of the heterocyclic ring shown in formula I being part of the aromatic or heteroaromatic ring system for the purpose of counting ring atoms). Preferred substituents $Ar^{13}$ and $Ar^{14}$ are phenyl rings.
If $R^{34}$ to $R^{38}$ represents an alkyl group, same has preferably 1 to 20, especially 1 to 8 carbon atoms and may be straight chain or branched. Particularly preferred alkyl groups are $C_1$ to $C_4$ alkyl, like methyl, ethyl, i- or n-propyl and i-, n- and t-butyl. The alkyl groups may themselves be substituted or unsubstituted.

Preferred carbocyclic groups for $R^{34}$ to $R^{38}$ are 5 to 7 membered carbocyclic ring systems, which may be saturated or unsaturated like e.g. cyclopentane, cyclohexane or cyclohexene, to give only three examples. As for the alkyl groups, the carbocyclic groups may be substituted or unsubstituted.

Preferred aryl groups for $R^{34}$ to $R^{38}$ are are phenyl, napththyl, anthracenyl, biphenyl or terphenyl, which may be unsubstituted or substituted by substituents selected from the group consisting of halogen, alkyl, alkoxy, amino, cyano, alkenyl, alkynyl, arylalkyl, aryl and heteroaryl groups or the aryl group may be part of an annealed ring system.

The following examples show spirobifluorene compounds which have proved to be advantageous in the compositions of the present invention under certain circumstances

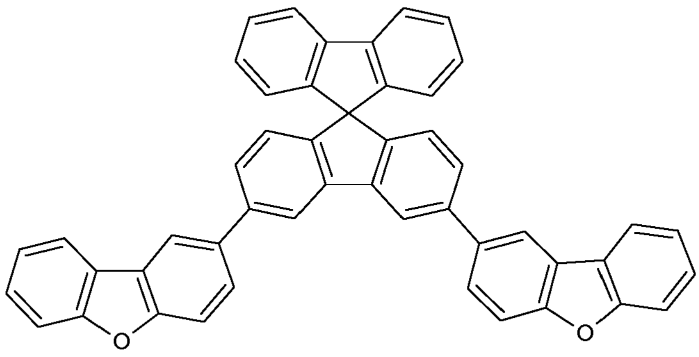

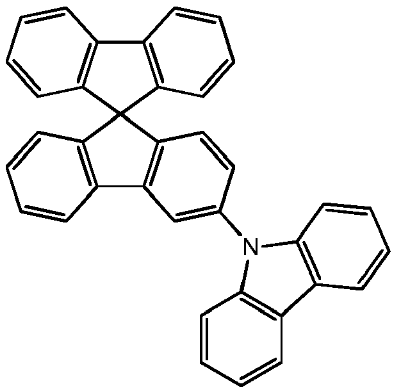

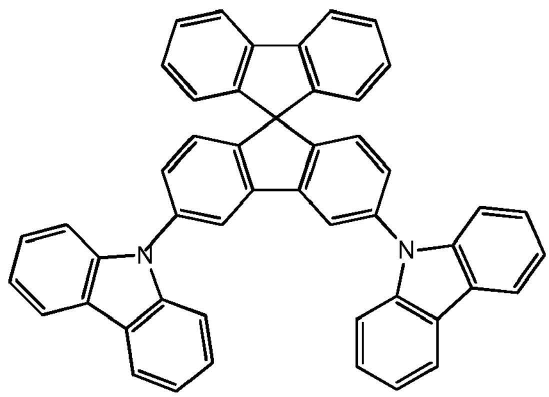

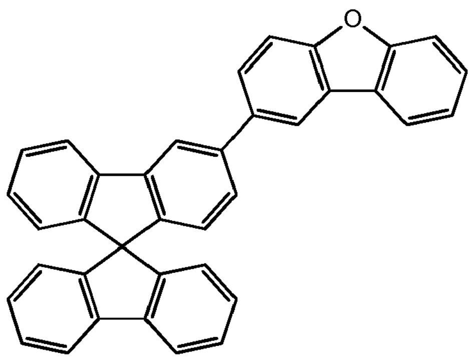

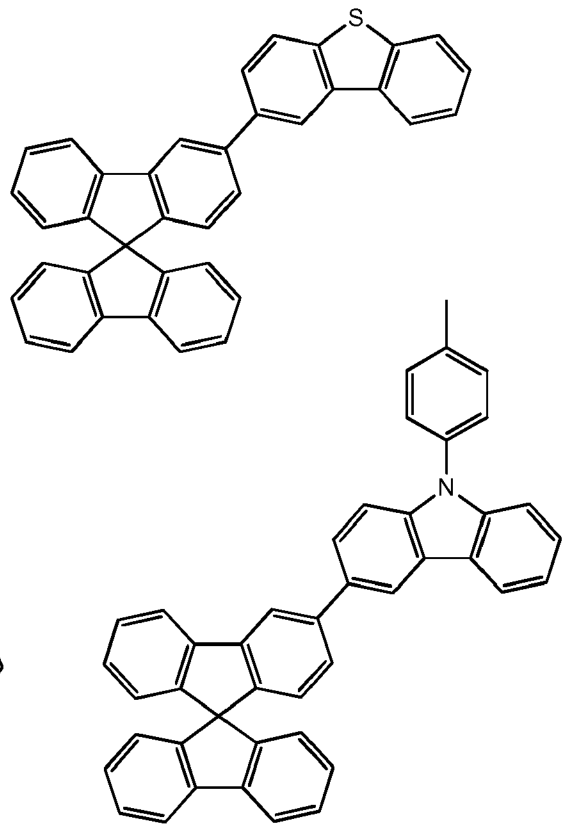

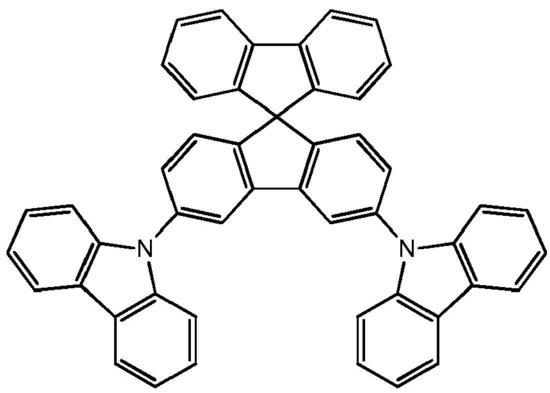

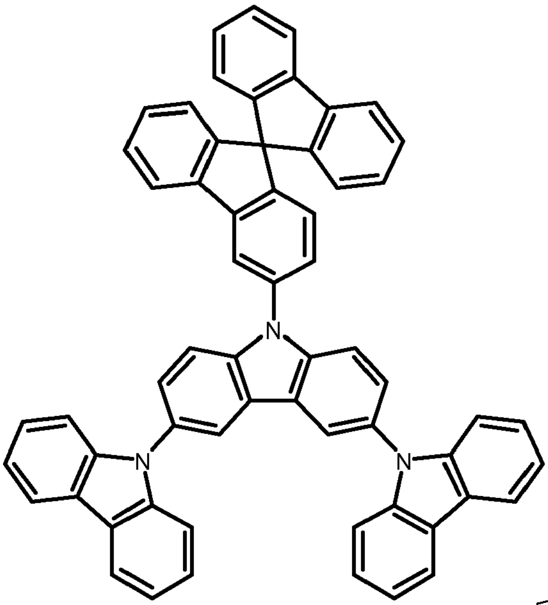

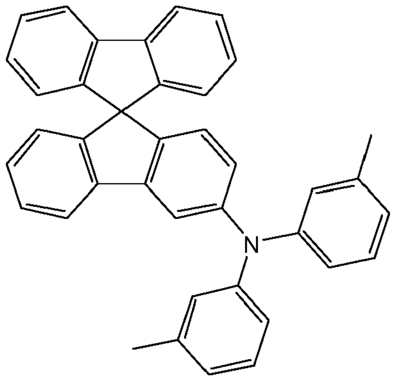

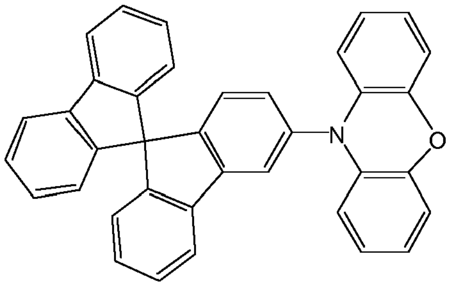

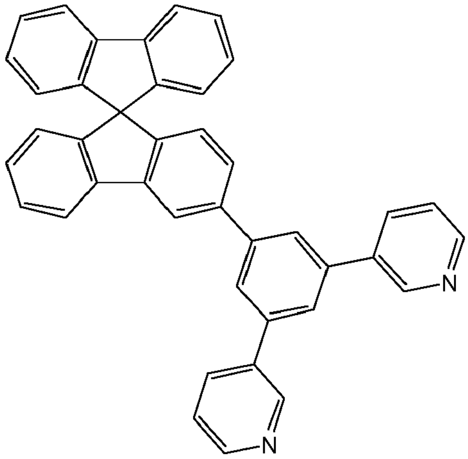

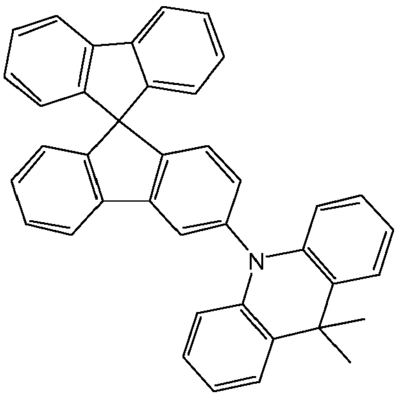

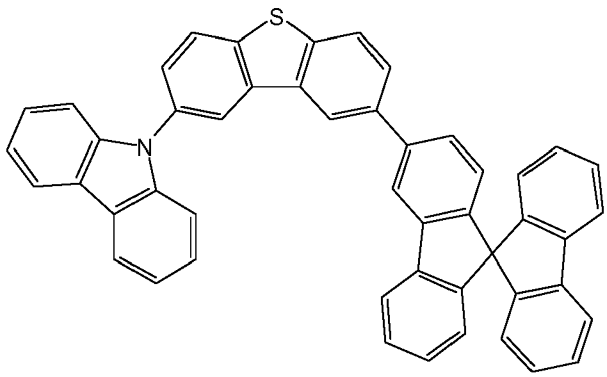

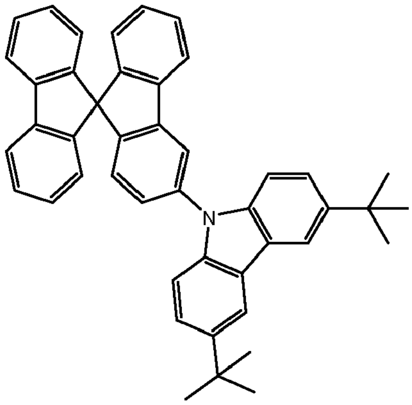

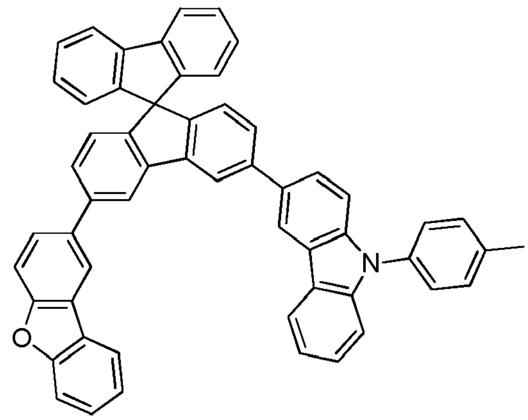

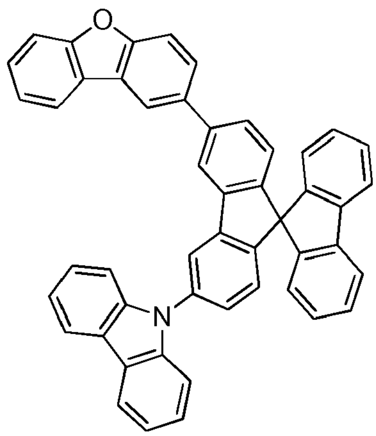

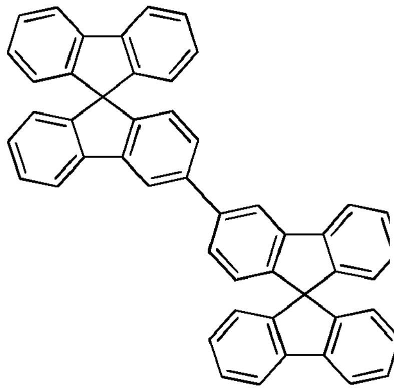

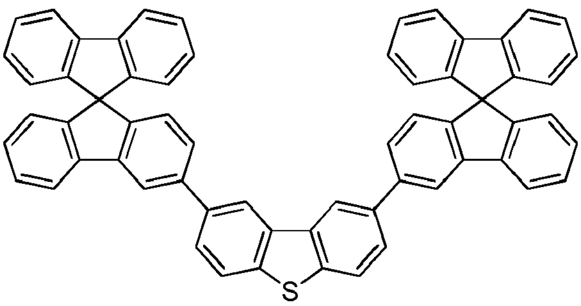

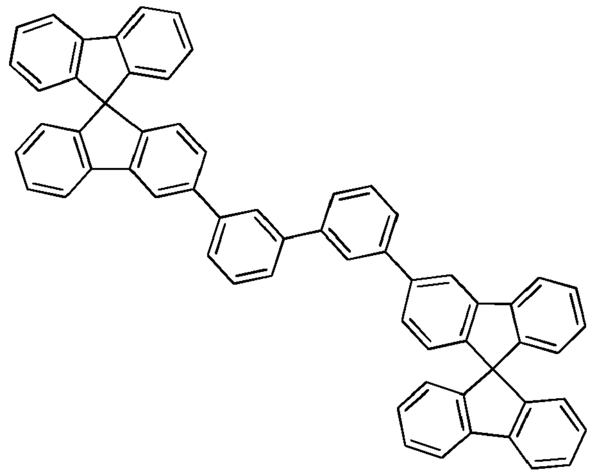

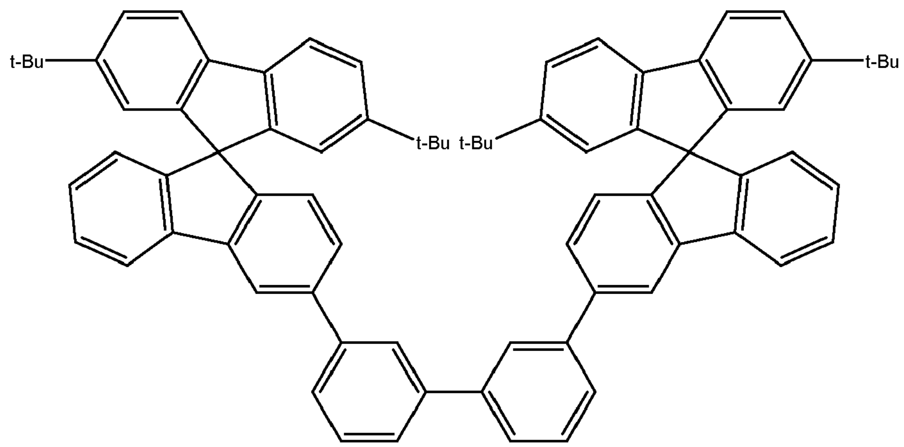

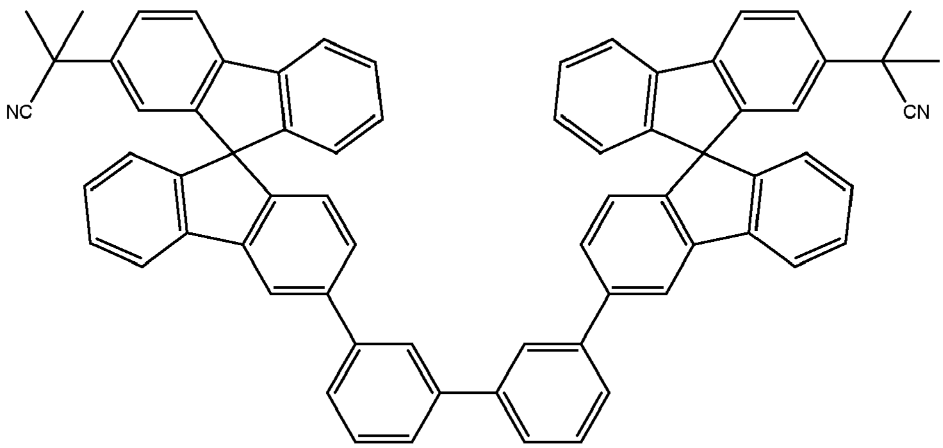

In certain cases it has been advantageous if the SBF compound used in the compositions of the present invention have a HOMO-Level of less than -5.1 eV, preferably less than -5.5 eV and most preferably a HOMO level of less than -5.7 eV.

The organic semiconducting material and the spirobifluorene compound may be present in the compositions according to the present invention in a weight ratio of from 1:99 to 99:1, preferably in the weight ratio of from 25:75 to 75:25 and even more preferably in the weight ratio of 66:34 to 34:66.

The organic semiconductor compositions in accordance with the present invention in accordance with a preferred embodiment in addition comprise one or more organic solvents. In such case, the total solid content (combined content of organic semiconductor and spirobifluorene compound) of the composition is preferably in the range of from

0.5 to 10 preferably of from 1 to 5, more preferably of from 1 to 3 wt%.

The viscosity of the solvents preferably is in the range of from 0.2 to 50 mPas, preferably in the range of from 1 to 20 mPas, measured at 25°C.

The Hansen solubility parameters of the solvent used are preferably within the following ranges:

Hd: 15 to 25, preferably 17 to 23
Hp: 0 to 20, preferably 0 to 15
Hh: 0 to 25, preferably 0 to 20
and the solid surface tension in mN/m is preferably in the range of from 10 to 70, more preferably in the range of from 20 to 50 and most preferably in the range of from 26 to 38.

Examples of suitable and preferred organic solvents include, without being limited to, dichloromethane, trichloromethane, monochlorobenzene, o-dichlorobenzene, the respective bromobenzenes, tetrahydrofuran, anisole, morpholine, toluene, o-xylene, m-xylene, p-xylene, the isomeric trimethylbenzenes, in particular 1,3,5 trimethylbenzene (also known as mesitylene), 1,4-dioxane, acetone, 1,1,2,2-tetrachloroethane, ethyl acetate, n-butyl acetate, dimethylformamide, dimethylacetamide, dimethylsulfoxide, tetralin (tetrahydronaphthalene), halogenated naphthalenes, such as 1-bromo naphthalene, decalin, indane and/or mixtures thereof.

Especially preferred solvents for use in the compositions according to the present invention are the isomeric xylenes, toluene, mesitylene, tetralin, chlorobenzene, bromobenzene, o-dichlorobenzene and 1-bromonaphthalin.

The preferred solvents having a boiling point in the range of from 80 to 350, preferably of from 100 to 300 and even more preferably of from 130 to 230°C.

Liquid coating of organic electronic devices such as field effect transistors is generally preferred over vacuum deposition techniques. The organic semiconductor compositions in accordance with the present invention enable the use of a number of liquid coating techniques.

Just by way of example dip coating, spin coating, slit die coating, inkjet printing, letter-press printing, screen printing, doctor blade coating, roller printing, reverse roller-printing, offset lithography printing, flexographic printing, spray coating, brush coating or pad printing may be mentioned here.

The ink jet fluid (i.e. the mixture of semiconducting compounds, binder and solvent) preferably has a viscosity at 20°C of 1-100 mPas, more preferably of 1-50 mPas and most preferably 1-30 mPas.

The semiconducting layer obtained through the use of the organic semiconductor composition in accordance with the present invention in the organic electronic device is typically at most 1 $\mu$m thick, although greater thicknesses may be achieved if required. Exact thickness of the layout will depend upon the requirements of the electronic device in which the layer is used. For use in an organic field effect transistor or an organic light emitting diode, the layer thickness typically would be around 500 nm or less.

A substrate used for preparing the organic semiconducting layer may include any underlying device layer, electrode or separate substrate such as e.g. silicon wafer, glass or polymer substrate.

The organic semiconductor composition in accordance with the present invention can additionally comprise one or more further components like e.g. surface-active compounds, lubricating agents, wetting agents, dispersing agents, hydrophobic agents, adhesive agents, flow improvers, defoaming agents, deaerators, diluents (reactive or non-reactive), auxiliaries, colorants, dyes, pigments or nanoparticles.

The present invention furthermore relates to a electronic component or device comprising a gate electrode, a source electrode and a drain electrode, said component or device further comprising an organic semiconducting material between the source and drain electrode, which organic semiconducting material is obtained using an organic semiconductor composition in accordance with the present invention.

Preferred electronic components or devices are organic field effect transistors.

In accordance with a further embodiment of the present invention, a process for the manufacture of an electronic component or device comprising a gate electrode, a source electrode and a drain electrode is provided, comprising the following steps:

a) providing an organic semiconductor composition in accordance with the present invention, optionally with a solvent or solvent mixture,
b) applying the organic semiconductor composition obtained in step a) to a substrate;
c) optionally evaporating the solvent or the solvent mixture to form a solid layer comprising the organic semiconducting material,
d) optionally removing the solid layer obtained in step c) or the substrate from the solid layer.

The organic semiconductor compositions in accordance with the present invention may advantageously be used for the manufacture of organic electronic devices, in particular for organic field effect transistors.

The properties of the composition make same particularly suitable for use in such manufacturing processes and thereby organic electronic devices with advantageous properties can be obtained.

The following examples provide further information on the preferred embodiments of the present invention.

## Examples

Organic Thin Film Transistors (OTFTs) were fabricated in top gate and bottom contact configuration using glass based substrates as follows:

1" square glass substrates (ex: Corning XG) were cleaned using sonication bathes for 5 minutes in Deconex (3% in water) followed by rinsing in ultrapure water and dried using compressed air. A planarization layer was first spincoated on top of the cleaned substrates in order to create a 30 nm film after photo-crosslinking. Au (30 nm) bottom contact source/drain (S/D) electrodes were deposited on top of the buffer layer by thermal evaporation through a shadow mask. The 16 transistors S/D consisted of electrodes with channel length of 50μm and channel width of 0.5mm. The substrates then underwent UV/$O_3$ treatment (model 42-220, from Jelight Company, Inc.), treatment time 5min. Prior to spin coating of the OSC solution, a 10mM solution of 4-fluorobenzenethiol in 2-propanol was applied to the surface of the electrodes for 1 minute followed by spin coating and rinsing by fresh 2-propanol, followed by drying on a hotplate at 100 °C. The organic semiconductor (OSC) formulation was spin coated onto the SD electrodes using a Laurell spinner set at 1500 rpm followed by baking on a hotplate for 60 seconds at 100°C. A solution of Hyflon® AD SF (9.2% w/w) was spin coated at 3000 rpm and the samples were baked on a hotplate for 60s at 100°C. Gate electrodes were defined by evaporation of Aluminum through a shadow mask in a thermal evaporator system.

OTFT characterization

OTFTs were tested using a Cascade Microtech EP6 DC probe station in conjunction with an Agilent B1500A semiconductor parameter analyzer. The Agilent system calculated the linear mobility according to the equation shown below (Equation 2).

$$\mu_{Lin} = \frac{\partial I_{DS}}{\partial V_G} \frac{L}{W C_i V_{DS}}$$

where L is the transistor length, W is the transistor width and Ci is the dielectric capacitance per unit area. Vds was set at -4V unless otherwise stated. The mobility values reported are an average of the 5 highest points in accumulation for each transistor. The standard deviation of the mobility values is reported as a percentage of the mean.

### Comparative Examples (i) to (iv)

The OTFT arrays fabricated and characterized as the Comparative Examples (i) to (v) were fabricated and tested as described above. The formulations tested in the comparative examples included small molecule semiconductor however these formulations did not incorporate any binders.

### Comparative Example (i): 1,4,8,11-tetramethyl-6,13-Triethylsilylethynylpentacene without binder; TG OTFT

1,4,8,11-tetramethyl-6,13-triethylsilylethynylpentacene from the series of compounds (14) represented by Formula (19) was formulated in tetralin at 2% by weight total solids content. This was coated as an OSC layer in an OTFT device according to the method shown above for glass substrate. The TFT performance of this formulation is shown in Table (i) below:

| | |
|---|---|
| μ Lin | 1.8±0.8 $cm^2/Vs$ |

### Comparative Example (ii): 2,8-Difluoro-5,11-bis(triethylsilylethynyl) anthradithiophene without binder, TG OTFT

2,8-Difluoro-5,11-bis(triethylsilylethynyl)anthradithiophene from the series of compounds (15) represented by Formula (20) was formulated in tetralin at 2% by weight total solids content. This was coated as an OSC layer in an OTFT device according to the method shown above for glass substrate. The TFT performance of this formulation is shown in Table (i) below:

| | |
|---|---|
| μ Lin | 0.3±0.1 $cm^2/Vs$ |

**Comparative Example (iii): 2,7-dioctyl[1]benzothieno[3,2-b][1]benzothiophene without binder, TG OTFT**

2,7-dioctyl[1]benzothieno[3,2-b][1]benzothiophene from the series of compounds (16) represented by Formula (21) was formulated in tetralin at 2% by weight total solids content. This was coated as an OSC layer in an OTFT device according to the method shown above for glass substrate. The TFT performance of this formulation is shown in Table (i) below:

| | |
|---|---|
| μ Lin | 0.3±0.2 $cm^2/Vs$ |

**Comparative Example (iv): 1,1'-di(decan-5-yl)-7,7'-difluoro-1H,1'H-3,3'-bipyrrolo[2,3-b]quinoxaline-2,2'(4H,4'H)-dione without binder, TG OTFT**

1,1'-di(decan-5-yl)-7,7'-difluoro-1H,1'H-3,3'-bipyrrolo[2,3-b]quinoxaline-2,2'(4H,4'H)-dione from the series of compounds (24) represented by Formula (25) was formulated in tetralin at 2% by weight total solids content. This was coated as an OSC layer in an OTFT device according to the method shown above for glass substrate.

The TFT performance of this formulation is shown in Table (i) below:

| | |
|---|---|
| μ Lin | 0.1±0.08 $cm^2/Vs$ |

**Comparative Examples (v) to (viii)**

The OTFT arrays fabricated and characterized as the Comparative Examples (v) to (ix) were fabricated and tested as described above. The formulations tested in the comparative examples (v) to (ix) included a small molecule semiconductor and a polymer as binder.

**Comparative Example (v): 1,4,8,11-tetramethyl-6,13-Triethylsilylethynylpentacene with polymer binder; TG OTFT**

1,4,8,11-tetramethyl-6,13-triethylsilylethynylpentacene from the series of compounds (14) represented by Formula (19) and Poly[bis(4-phenyl)(2,4,6-trimethylphenyl)amine] were formulated in tetralin in a ratio 1:1 at total solids content of 2% by weight. This was coated as an OSC layer in an OTFT device according to the method shown above for glass substrate.

The TFT performance of this formulation is shown in Table (i) below:

| | |
|---|---|
| μ Lin | 3.8±1.1 $cm^2/Vs$ |

**Comparative Example (vi): 2,8-Difluoro-5,11-bis(triethylsilylethynyl) anthradithiophene with polymer binder, TG OTFT**

2,8-Difluoro-5,11-bis(triethylsilylethynyl)anthradithiophene from the series of compounds (15) represented by Formula (20) and Poly[bis(4-phenyl)(2,4,6-trimethylphenyl)amine] were formulated in tetralin in a ratio 1:1 at total solids content of 2% by weight. This was coated as an OSC layer in an OTFT device according to the method shown above for glass substrate.

The TFT performance of this formulation is shown in Table (i) below:

| | |
|---|---|
| μ Lin | 2.2±0.8 $cm^2/Vs$ |

**Comparative Example (vii): 2,7-dioctyl[1]benzothieno[3,2-b][1]benzothiophene with polymer binder, TG OTFT**

2,7-dioctyl[1]benzothieno[3,2-b][1]benzothiophene from the series of compounds (16) represented by Formula (21) and Poly[bis(4-phenyl)(2,4,6-trimethylphenyl)amine] were formulated in tetralin in a ratio 1:1 at total solids content

of 2% by weight. This was coated as an OSC layer in an OTFT device according to the method shown above for glass substrate.

The TFT performance of this formulation is shown in Table (i) below:

| | |
|---|---|
| μ Lin | 0.1±0.06 $cm^2/Vs$ |

**Comparative Example (viii): 1,1'-di(decan-5-yl)-7,7'-difluoro-1H,1'H-3,3'-bipyrrolo[2,3-b]quinoxaline-2,2'(4H,4'H)-dione with polymer binder, TG OTFT**

1,1'-di(decan-5-yl)-7,7'-difluoro-1H,1'H-3,3'-bipyrrolo[2,3-b]quinoxaline-2,2'(4H,4'H)-dione from the series of compounds (24) represented by Formula (25) and Poly[bis(4-phenyl)(2,4,6-trimethylphenyl)amine] were formulated in tetralin in a ratio 1:1 at total solids content of 2% by weight. This was coated as an OSC layer in an OTFT device according to the method shown above for glass substrate.

The TFT performance of this formulation is shown in Table (i) below:

| | |
|---|---|
| μ Lin | 0.1±0.08 $cm^2/Vs$ |

**Examples 1 to 4**

The OTFT arrays fabricated and characterized as the Examples (1) to (5) were fabricated and tested as described above. The formulations tested in the examples (1) to (5) included small molecule semiconductor and an amorphous small-molecule as binder. In these examples the ratio of binder to the semiconductor is in parts by weight.

**Example (1): 1,4,8,11-tetramethyl-6,13-Triethylsilylethynylpentacene with small-molecule binder; TG OTFT**

Binder 3-(9,9'-spirobi[fluorene]-3-yl)-3'-(9,9'-spirobi[fluorene]-6-yl)biphenyl was formulated with 1,4,8,11-tetramethyl-6,13-triethylsilylethynyl pentacene from the series of compounds (14) represented by Formula (19) in a ratio 1:1 at a total solids content of 2% by weight in tetralin and coated as an OSC layer in an OTFT device according to the method shown above for glass substrate devices.

The TFT performance of this formulation is shown in Table (i) below:

| | |
|---|---|
| μ Lin | 3.8±0.3 $cm^2/Vs$ |

**Example (2): 2,8-Difluoro-5,11-bis(triethylsilylethynyl) anthradithiophene with small-molecule binder; TG OTFT**

Binder 3-(9,9'-spirobi[fluorene]-3-yl)-3'-(9,9'-spirobi[fluorene]-6-yl)biphenyl was formulated with 2,8-Difluoro-5,11-bis(triethylsilylethynyl)anthradithiophene from the series of compounds (15) represented by Formula (20) in a ratio 1:1 at a total solids content of 2% by weight in tetralin and coated as an OSC layer in an OTFT device according to the method shown above for glass substrate devices. The TFT performance of this formulation is shown in Table (i) below:

| | |
|---|---|
| μ Lin | 3.3±0.5 $cm^2/Vs$ |

**Example (3): 2,7-dioctyl[1]benzothieno[3,2-b][1]benzothiophene with small-molecule binder; TG OTFT**

Binder 3-(9,9'-spirobi[fluorene]-3-yl)-3'-(9,9'-spirobi[fluorene]-6-yl)biphenyl was formulated with 2,7-dioctyl[1]benzothieno[3,2-b][1]benzothiophene from the series of compounds (16) represented by Formula (21) in a ratio 1:1 at a total solids content of 2% by weight in tetralin and coated as an OSC layer in an OTFT device according to the method shown above for glass substrate devices.

The TFT performance of this formulation is shown in Table (i) below:

| | |
|---|---|
| μ Lin | 0.4±0.07 $cm^2/Vs$ |

**Example (4): 1,1'-di(decan-5-yl)-7,7'-difluoro-1H,1'H-3,3'-bipyrrolo[2,3-b]quinoxaline-2,2'(4H,4'H)-dione with small-molecule binder; TG OTFT**

Binder 3-(9,9'-spirobi[fluorene]-3-yl)-3'-(9,9'-spirobi[fluorene]-6-yl)biphenyl was formulated with 11'-di(decan-5-yl)-7,7'-difluoro-1H,1'H-3,3'-bipyrrolo[2,3-b]quinoxaline-2,2'(4H,4'H)-dione from the series of compounds (24) represented by Formula (25) in a ratio 1:1 at a total solids content of 2% by weight in tetralin and coated as an OSC layer in an OTFT device according to the method shown above for glass substrate devices.

The TFT performance of this formulation is shown in Table (i) below:

| | |
|---|---|
| μ Lin | 0.13±0.005 $cm^2/Vs$ |

The previous examples show that the organic semiconductor compositions in accordance with the present invention, comprising an organic semiconductor and a monomeric binder on the basis of substituted or unsubstituted spirobifluorene yield OTFTs with improved perfomance compared to OTFTs obtained using compositions in accordance with the prior art.

## Claims

1. Organic semiconductor composition, comprising an organic semiconductor (OSC) material a) and a binder b) which is a spirobifluorene compound comprising 1 to 4 substituted or unsubstituted spirobifluorene moieties of formula (26)

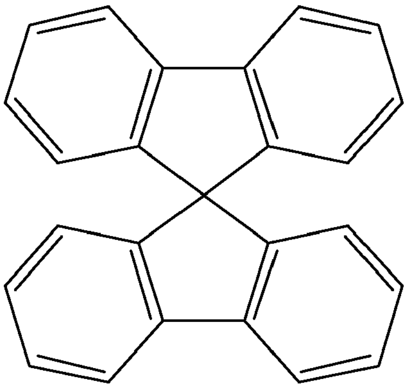

(26)

2. Organic semiconductor compositions in accordance with claim 1 wherein the spirobifluorene compound has a molecular weight of 1500 Daltons or less.

3. Organic semiconductor compositions in accordance with any of claims 1 or 2 additionally comprising one or more organic solvents.

4. Organic semiconductor composition in accordance with any of claims 1 to 3 wherein the binder b) has a glass transition temperature of at least 120 °C,

5. Organic semiconductor composition in accordance with any of claims 1 to 4 wherein the spirobifluorene compound is a 3-substituted 9,9'-spirobifluorene compound.

6. Organic semiconductor compositions in accordance with any of claims 1 to 5 wherein the organic semiconductor material has a field effect mobility of at least 0.001 $cm^2/Vs$.

7. Organic semiconductor composition in accordance with any of claims 1 to 6 wherein the organic semiconductor is a small molecule with a molecular weight of 1500 Da or less.

8. Organic semiconductor composition in accordance with any of claims 1 to 7 wherein the SBF compound has a HOMO level of -5.1 eV or less.

**9.** Organic semiconductor composition in accordance with any of claims 1 to 8 wherein the weight ratio of organic semiconductor to binder is from 1:99 to 99:1.

**10.** Electronic component or device comprising a gate electrode, a source electrode and a drain electrode, said component further comprising an organic semiconducting material between the source and the drain electrode, which organic semiconducting material is obtained using an organic semiconductor composition in accordance with any of claims 1 to 9.

**11.** A process for the manufacture of an electronic component or device in accordance with claim 10 comprising the following steps:

a) providing an organic semiconductor composition in accordance with claims 1 to 9, optionally with a solvent or solvent mixture,
b) applying the organic semiconductor composition obtained in step a) to a substrate;
c) optionally evaporating the solvent or the solvent mixture to form a solid layer comprising the organic semiconducting material,
d) optionally removing the solid layer obtained in step c) or the substrate from the solid layer.

**12.** Use of the organic semiconductor composition in accordance with any of claims 1 to 9 for the manufacture of organic electronic devices.

**13.** Use in accordance with claim 12 wherein the organic electronic device is an organic field effect transistor.

Europäisches Patentamt
European Patent Office
Office européen des brevets

# EUROPEAN SEARCH REPORT

Application Number
EP 14 19 7724

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FUKAGAWA HIROHIKO ET AL: "Anthracene derivatives as efficient emitting hosts for blue organic light-emitting diodes utilizing triplet-triplet annihilation", ORGANIC ELECTRONICS, ELSEVIER, AMSTERDAM, NL, vol. 13, no. 7, 29 March 2012 (2012-03-29), pages 1197-1203, XP028857186, ISSN: 1566-1199, DOI: 10.1016/J.ORGEL.2012.03.019<br>* the whole document *<br>----- | 1,2,4, 7-9,11, 12 | INV. H01L51/05 |
| A | LIM E ET AL: "Synergistic effect of polymer and oligomer blends for solution-processable organic thin-film transistors", ORGANIC ELECTRONICS, ELSEVIER, AMSTERDAM, NL, vol. 9, no. 6, 1 December 2008 (2008-12-01), pages 952-958, XP025546145, ISSN: 1566-1199, DOI: 10.1016/J.ORGEL.2008.06.018 [retrieved on 2008-07-08]<br>* the whole document *<br>----- | 1-13 | TECHNICAL FIELDS SEARCHED (IPC)<br>H01L |
| A | KWON JAE-HONG ET AL: "Organic thin film transistors using 6,13-bis(tri-isopropylsilylethynyl)pentacene embedded into polymer binders", APPLIED PHYSICS LETTERS, AMERICAN INSTITUTE OF PHYSICS, US, vol. 94, no. 1, 8 January 2009 (2009-01-08), pages 13506-13506, XP012118255, ISSN: 0003-6951, DOI: 10.1063/1.3063123<br>* the whole document *<br>----- | 1-13 | |

1

The present search report has been drawn up for all claims

| Place of search | Date of completion of the search | Examiner |
|---|---|---|
| The Hague | 18 May 2015 | Königstein, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 200438459 B
- WO 200555248 A
- WO 200782584 A
- WO 2014008971 A
- WO 2012164282 A
- WO 2008011957 A
- WO 2012076092 A
- WO 2012076029 A
- WO 2006125504 A
- WO 2005055248 A
- WO 2007082584 A
- WO 2011031659 A
- WO 2012160383 A
- WO 2013041822 A
- EP 2014060845 W
- WO 2012048819 A
- WO 201248820 A
- WO 2013045408 A
- WO 2013045410 A

### Non-patent literature cited in the description

- *Chem. Comm.,* 2014, vol. 50, 5342-5344